# EUROPÄISCHE PATENTSCHRIFT

(11) **EP 1 462 808 B1**
(45) Veröffentlichungstag und Bekanntmachung des Hinweises auf die Patenterteilung: **24.08.2016**
(21) Anmeldenummer: 04007202.7
(22) Anmeldetag: 25.03.2004
(51) Int. Cl.: G01R 22/06

(54) **Anschlussvorrichtung für einen Stromzähler**
Connecting device for an electricity meter
Dispositif de connexion pour un compteur d'électricité

(30) Priorität: 27.03.2003 DE 10313999; 16.05.2003 DE 10323161
(43) Veröffentlichungstag der Anmeldung: 29.09.2004
(60) Teilanmeldung: 12187511.6
(73) Patentinhaber: Hager Electro GmbH & Co. KG, 66440 Blieskastel (DE)
(72) Erfinder: Clemens, Guntram, 90409 Nürnberg (DE); Kelaiditis, Konstantin, 66386 St. Ingbert (DE); Zimmermann, Manfred, 66131 Saarbrücken (DE); Zimmermann, Michael, 66399 Mandelbachtal (DE)
(74) Vertreter: Nuss, Laurent

(56) Entgegenhaltungen:
- DE-A- 10 052 998
- DE-A- 10 054 771
- DE-C- 669 192
- US-A- 3 369 088
- US-A- 4 388 670
- US-A- 6 059 605

## Beschreibung

Die Erfindung betrifft eine Anschlussvorrichtung für einen Stromzähler, der ein Gehäuse aufweist, von dessen gegen eine Tragplatte der Anschlussvorrichtung anlegbarem Boden durch Öffnungen in der Tragplatte hindurchführbare Kontaktstifte entsprechend wenigstens einer Stromphase vorstehen, welche durch Verschiebung des auf der Tragplatte geführten Gehäuses mit Strom zu- und abführenden Anschlusselementen der Anschlussvorrichtung auf der dem Stromzähler abgewandten Seite der Tragplatte verbindbar sind, wobei die Anschlusselemente an den Kontaktelementen zangenartig mit durch die Verschiebebewegung der Kontaktelemente aufspreizbaren federkraftbeaufschlagten Zangenbacken angreifen.

Eine solche Anschlussvorrichtung geht aus der DE 100 52 998 A1 hervor. Die Anschlusselemente dieser bekannten Anschlussvorrichtungen sind durch federnde Kupferblechstreifen gebildet, welche gegen die als runde Stifte ausgebildeten Kontaktelemente in der Anschlussposition des Zählers tangential anliegen, wobei die Anpresskraft des federnden Anschlusselements über das Stromzählergehäuse auf die Tragplatte übertragen wird. Durch die beim Anschluss des Stromzählers verschobenen Kontaktstifte wird ein federndes Überbrückungselement aus einer Überbrückungsposition durch Verbiegung in eine Offenstellung überführt.

Die US 3,369,088 beschreibt eine Anschlussvorrichtung für einen Stromzähler, der mit vorstehenden Kontaktelementen auf einen Anschlusssockel aufsteckbar ist, wobei die vorstehenden Kontaktelemente in federnde, zangenartig an den Kontaktelementen angreifende Anschlusselemente (46,47) einsteckbar sind. Eine schlittenartige, an dem Anschlusssockel anbringbare Überbrückungseinrichtung umfasst jeweils der zwei Anschlusselemente mit einander verbindende Blechstreifen (25,26), wobei die schlittenartige Überbrückungseinrichtung durch Verschiebung senkrecht zur Einsteckrichtung des Stromzählers zwischen einer Offenstellung und einer Verbindungsstellung hin und her bewegbar ist.

Der vorliegenden Erfindung liegt die Aufgabe zugrunde, eine neue Anschlussvorrichtung der eingangs erwähnten Art zu schaffen, die bei verringertem Platzbedarf eine höhere Kontaktsicherheit ermöglicht.

Die diese Aufgabe lösende Anschlussvorrichtung nach der Erfindung ist dadurch gekennzeichnet, dass die Anschlusselemente durch einen in Verschiebungsrichtung des Stromzählers verschiebbar geführten Blechstreifen unter zangenartigem Angreifen der Zangenbacken an dem Blechstreifen überbrückbar sind und der Blechstreifen mit einer Randausnehmung für den Eingriff eines der Kontaktelemente ausgebildet ist, durch dass sich der Blechstreifen beim Anschluss des Stromzählers aus einer Überbrückungsposition in eine Offenstellung verschieben lässt.

Gemäß dieser Erfindungslösung werden die Kontaktelemente, bei denen es sich vorzugsweise um Stifte mit einer länglichen Querschnittsfläche handelt, deren Längsachse sich in der Verschiebungsrichtung des Stromzählers erstreckt, zangenartig auf gegenüberliegenden Seiten ergriffen, wodurch große, der Kontaktsicherheit dienende Klemmkräfte erzeugt werden können. Eine solche Anschlussvorrichtung erfordert quer zur Vorschubrichtung des Zählers nur wenig Bauraum, so dass auf der Tragplatte für herkömmlich mittels Zählerkreuz befestigter Zähler zwei elektronische Zähler und zusätzlich unter der Tragplatte zwischen den Anschlussvorrichtungen Kabelkanäle Platz haben. Bei Verschiebungen ist keine unnötige Öffnungsarbeit zu leisten. Beim Anschluss des Zählers nimmt das Kontaktelement das Überbrückungsteil mit, so dass das Überbrückungsteil an einem Ende aus dem Zangengriff des Anschlusselements gelöst wird.

In der bevorzugten Ausführungsform der Erfindung sind die Zangenbacken durch die beiden Schenkel einer im wesentlichen U-förmigen Feder gebildet, wobei die U-Schenkel unter Bildung schiefer Ebenen aufgespreizt sind, um das Einschieben des Kontaktelements zu erleichtern. Die Feder kann massiv aus Kupfer hergestellt sein. Zweckmäßig wird jedoch eine Stahlfeder verwendet, wobei auf wenigstens einer Innenbackenseite ein Änschlussleiter aus Kupfer angeordnet ist.

Um toleranzbedingte Dickenunterschiede auszugleichen, können die Anschlusselemente voneinander unabhängig durch das Überbrückungsteil und das Kontaktelement aufspreizbare Zangenbackenteile aufweisen.

Zweckmäßig ist die Länge des Überbrückungsteils so bemessen, dass die Anschlusselemente in einer Zwischenstellung des Überbrückungsteils sowohl durch das Überbrückungsteil als auch den Stromzählerverbunden sind. Nachteilige Stromunterbrechungen beim Zählerwechsel werden dadurch vermieden.

In weiterer vorteilhafter Ausgestaltung der Erfindung kann das Überbrückungsteil in eine Trennposition mit einem der Netzspannung genügenden Trennabstand verschiebbar sein, wobei das Überbrückungsteil in der Trennposition zweckmäßig arretierbar und die Arretierung mittels eines durch eine der Öffnungen einführbaren Spezialwerkzeugs, welches nur dem betreffenden Energieversorgungsunternehmen zur Verfügung steht, lösbar ist.

In weiterer vorteilhafter Ausgestaltung der Erfindung können Überbrückungsteile für mehrere Stromphasen, insbesondere drei Phasen, untereinander durch isolierende Teile verbunden sein. Somit liegt nur ein einziges Überbrückungselement für alle Phasen vor.

Zweckmäßig sind die Anschlusselemente auf der dem Stromzähler abgewandten Seite an der Tragplatte angebracht.

Die Tragplatte kann ferner zur Befestigung eines Stromzählers mittels Zählerkreuz in herkömmlicher Weise vorgesehen sein, wobei in der Mitte zwischen z.B. zwei auf der Tragplatte angebrachten Stromzählern der Schlitz für die Anbringung des waagerechten Zählerkreuzes verlauft.

In weiterer vorteilhafter Ausgestaltung der Erfindung ist auf wenigstens einer der Backeninnenseiten ein Anschlussleiter aus Kupfer gebildet, der mit einem massiven, zu einer Anschlussklemme führenden Leiterstück in Verbindung steht, wobei der Anschlussleiter einstückig mit dem Leiterstück und das Leiterstück unmittelbar mit der Anschlussklemme verbunden ist.

Vorteilhaft bilden der Anschlussleiter und das den Anschlussleiter mit der Anschlussklemme verbindende Leiterstück ein einziges, leicht montierbares Teil, was die Fertigung einer solchen Anschlussvorrichtung vereinfacht.

Vorteilhaft weist der Anschlussleiter und das damit einstückig verbundene Leiterstück einen, ggf. durch Biegung vorgeformten, Blechstreifen auf, der sich mit geringem Aufwand ausstanzen und ggf. biegen lässt.

Während es denkbar wäre, einen Steckeransatz oder ein Druckstück für die Verbindung mit der Anschlussklemme an dem Leiterstück durch Schweißen oder Löten anzubringen, ist in einer bevorzugten Ausführungsform der Erfindung ein solcher Steckeransatz oder Druckstück einteilig an das Leiterstück angeformt. Ein Druckstück lässt sich durch Verdrehen oder Einschneiden und Abwinkeln des Blechstreifens bilden. Ein Steckeransatz wird zweckmäßig durch Einschneiden des Blechstreifens auf wenigstens einer Längsseite und Biegen, vorzugsweise Rollen, des durch den Einschnitt teilweise abgetrennten Endstückes des Blechstreifens um die Streifenlängsachse hergestellt. Vorteilhaft ist so für das gesamte Leiterstück einschließlich des Verbindungsmittels zur Leiste nur ein einziger Blechstreifen als Ausgangsteil erforderlich.

Die Ausführungsform mit einem Steckeransatz kommt insbesondere bei einem Adapter für einen Stromzähler in Betracht, welcher über die Steckeransätze an eine Zählersteckklemme auf einer Zöhlertragplatte, die für einen anderen Zähler vorbereitet ist, angeschlossen werden kann.

Der Anschlussleiter kann einschenklig oder zweischenklig in U-Form mit einem am freien Ende einteilig in das Leiterstück übergehenden U-Schenkel ausgebildet sein.

Zur Federbeaufschlagung kann eine gegen das Kontaktelement anlegbare Feder zum Druck des Kontaktelements gegen den Anschlussleiter vorgesehen sein. Hierbei kann es sich um eine einschenklige Blattfeder oder eine U-förmig gebogene Feder handeln, die mit einem U-Schenkel gegen das Kontaktelement und mit dem anderen U-Schenkel gegen den Anschlussleiter anliegt.

Alternativ kann eine solche U-Feder mit ihren beiden U-Schenkeln die Außenseiten beider Schenkel eines U-förmigen Anschlussleiters beaufschlagen.

Der Anschlussleister oder/und das Leiterstück können selbstfedernd sein, um entweder die den elektrischen Kontakt haltende Federkraft aufzubringen oder die Federkraft einer Stahlfeder zu unterstützen.

In weiterer Ausgestaltung der Erfindung weist das Leiterstück wenigstens eine dem Leiterstück Flexibilität verleihende Schwachstelle auf, durch die sich Abmessungstoleranzen ausgleichen lassen.

Das Leiterstück kann zwischen Haltestegen einlegbar sein, die an die Form des Leiterstücks angepasst sind.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: einen mit Hilfe der Vorrichtung nach der Erfindung anschließbaren elektronischen Zähler in einer Ansicht von unten,
- Fig. 2: den Zähler von Fig. 1 in einer Seitenteilansicht,
- Fig. 3: einen Ausschnitt aus einer den Zähler von Fig. 1 aufnehmenden Tragplatte,
- Fig. 4: Anschlusselemente und Überbrückungsteile gemäß einem ersten Ausführungsbeispiel für die Erfindung in einer Draufsicht,
- Fig. 5: eine Detailseitenansicht der Bauteile von Fig. 4,
- Fig. 6: Anschlusselemente und Verbindungsteile entsprechend einem zweiten Ausführungsbeispiel für die vorliegende Erfindung,
- Fig. 7: eine Trennstellung zwischen den in Fig. 6 gezeigten Anschluss- und Verbindungstellen,
- Fig. 8: einen die Vorrichtung nach der Erfindung verwendenden Zähler- und Verteilerschrank,
- Fig. 9: eine Anschlussvorrichtung für einen Stromzähler nach der Erfindung,
- Fig. 10: Details der Anschlussvorrichtung von Fig. 9,
- Fig. 11: ein weiteres Ausführungsbeispiel für ein in der Vorrichtung von Fig. 9 verwendbares Anschlusselement, und
- Fig. 12: eine Ausführungsform eines in der Vorrichtung von Fig. 9 verwendbaren Leiterstücks.

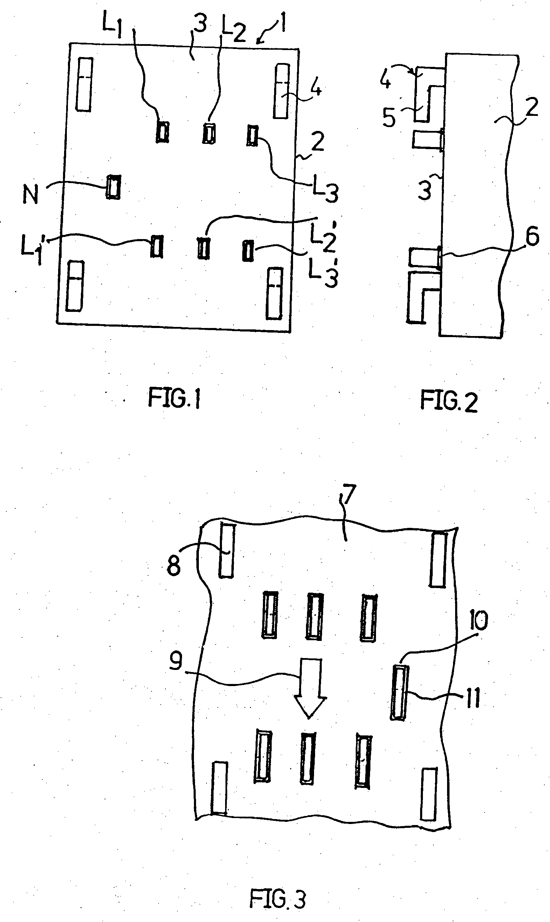

Ein in Fig. 1 und 2 gezeigter elektronischer Stromzähler weist ein isolierendes Gehäuse 2 aus Kunststoff mit einem ebenen Boden 3 auf. Von dem ebenen Boden 3 stehen an vier Ecken an den Boden einstückig angeformte Hakenteile 4 mit einem sich parallel zur Bodenfläche erstreckenden Hakenschenkel 5 vor.

Aus dem Boden 3 des Gehäuses 2 ragen ferner insgesamt sieben Kupferkontaktstifte heraus, von denen der Kontaktstift N zur Verbindung mit dem Neutralleiter vorgesehen ist. Entsprechend drei Stromphasen sind drei Kontaktstiftpaare L1, L1', L2, L2' und L3, L3' vorgesehen. An den Austrittsstellen der Kontaktstifte bildet das Kunststoffmaterial des Gehäusebodens 3 einen vorstehenden Wulst 6.

Eine in Fig. 3 ausschnittsweise gezeigte Tragplatte 7 für den Stromzähler 1 weist vier Schlitzöffnungen 8 auf, in welche die Hakenteile 4 beim Aufsetzen des Stromzählers 1 auf die Platte 7 eintreten. Bei Verschiebung des Stromzählers gemäß Pfeil 9 hintergreifen die Hakenschenkel 5 die Tragplatte 7. Die Schlitzöffnungen 8 bilden eine Führung für den Stromzähler 1.

Entsprechend den vorstehenden Kontaktstiften sind in der Tragplatte insgesamt sieben Öffnungen 10 mit einer Randabstufung 11 gebildet. Der die Randabstufung 11 ausfüllende Wulst 6 erschwert unbefugten Zugang zu den Kontaktelementen. Die in dem betreffenden Ausführungsbeispiel einen Querschnitt in Form eines länglichen Rechtecks aufweisenden Kontaktstifte sind innerhalb der Öffnungen 10 in Richtung des Pfeils 9 verschiebbar.

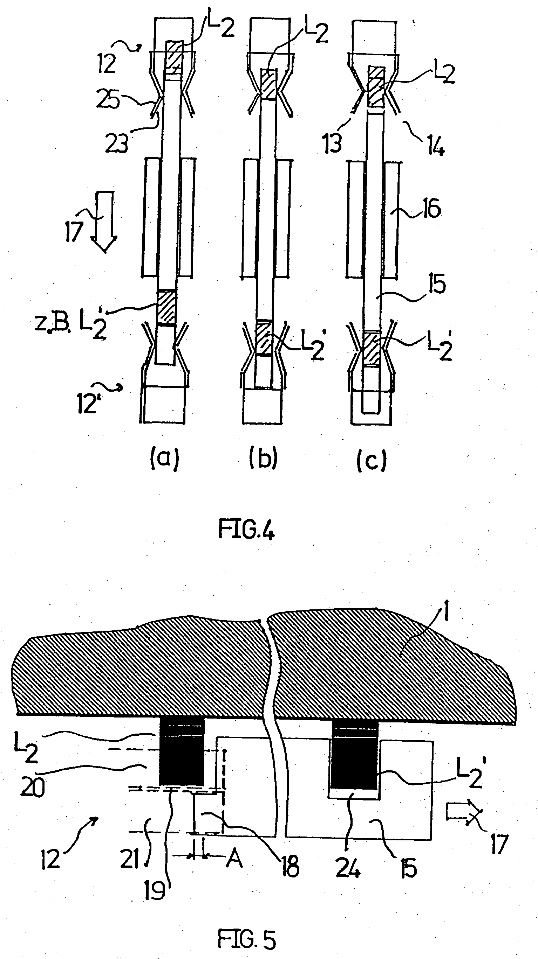

Es wird nun auf die Fig. 4 und 5 Bezug genommen, wo Anschlusselemente 12 und 12' gezeigt sind, welche an der dem Stromzähler 1 abgewandten Seite der Tragplatte 7 an der Tragplatte 7 angebracht sind.

Die eine im wesentlichen U-förmige Feder mit Schenkeln 13 und 14 aufweisenden Anschlusselemente 12 greifen in einem Zustand, in dem der Stromzähler 1 nicht oder gerade auf die Tragplatte 7 aufgesetzt ist, zangenartig an beiden Enden eines durch einen Blechstreifen gebildeten Überbrückungsteils 15 an. Die Blechdicke ist gleich der Dicke der Kontaktstifte. Die drei, jeweils eine Stromphase führenden Überbrückungsteile 15 sind jeweils in einer Führung 16 gemäß Pfeil 17 verschiebbar.

Wie insbesondere aus Fig. 5 hervorgeht, weisen die Überbrückungsteile 15 jeweils eine Randausnehmung 24 auf, in welche beim Aufsetzen des Stromzählers 1 auf die Tragplatte 7 die Kontaktstifte L1' bis L3' eingreifen. Beim Anschließen des Zählers und Verschieben des Zählers in Richtung des Pfeils 9 (Fig. 3) nehmen die betreffenden Kontaktstifte das Überbrückungsteil 15 mit und verschieben es in Richtung des Pfeils 17.

In Fig. 4b ist eine in Fig. 5 näher erläuterte Zwischenstellung gezeigt, in welcher die Kontaktstifte L1 bis L3 bereits in Kontakt mit dem betreffenden Anschlusselement 12 sind, die Überbrückungsteile 15 aber über eine Verlängerung 18 auch noch in Kontakt mit den Anschlusselementen stehen.

Wie Fig. 5 zeigt, existiert ein Überlappungsbereich A, in welchem diese Doppelkontaktierung vorliegt. Wie Fig. 5 ferner erkennen lässt, sind die Federschenkel 13 und 14 durch einen Schlitz 19 in Federschenkelteile 20 und 21 unterteilt, wobei die Kontaktstifte L1 bis L3 nur in Kontakt mit dem Schenkelteil 20 und die Verlängerung 18 nur in Kontakt mit dem Schenkelteil 21 steht. Toleranzbedingte Dickenunterschiede zwischen Kontaktstiften und Blech des Überbrückungsteils 15 können so nicht zur Aufhebung von Kontakten führen.

In Fig. 4c stehen nur noch die vom Boden des Stromzählers 1 vorstehenden Kontaktstifte in Verbindung mit den Anschlusselementen 12. An einem Ende der Überbrückungsteile 15 ist bei 22 eine Luft- und Kriechstrecke zu den betreffenden Anschlusselementen 12 gebildet.

In dem betreffenden Ausführungsbeispiel bestehen die Federn aus einem Innenteil 23 aus Kupfer und einem die Federwirkung verstärkenden Außenteil 25 aus Stahl. Von den Anschlusselementen 12 können mit diesen verbundene Stromkabel wegführen oder sie können Bestandteil eines vorgeformten massiven Leiterteils sein, das z.B. zu einer Anschlussleiste führt.

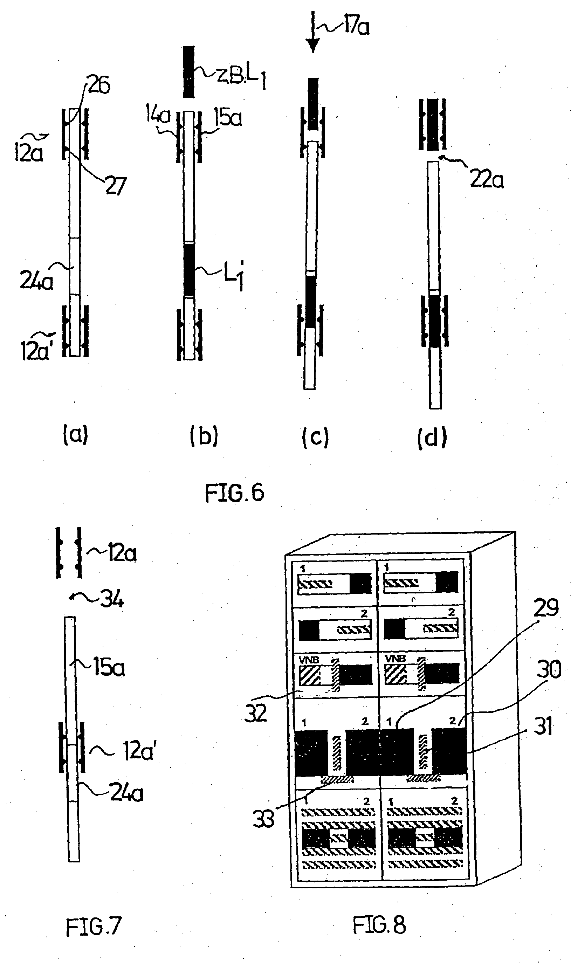

Fig. 6 erläutert nochmals anhand anderer Anschlusselemente die verschiedenen Anschlussphasen. In dem betreffenden Ausführungsbeispiel sind schematisch Anschlusselemente 12a gezeigt, deren Federschenkel (14a, 15a) parallel zur Tragplatte 7, wie die Federschenkel 13 und 14 der Anschlusselemente 12 oder senkrecht dazu verlaufen. In diesem Fall sind in Verschiebungsrichtung gemäß Pfeil 17a zwei Kontaktbuckel 26 und 27 vorgesehen. Zwischen den Kontaktbuckeln könnten die Federschenkel 14a und 15a aus obengenanntem Grund geschlitzt sein.

Fig. 6a zeigt die Stellung von Überbrückungsteilen 15a bei Abwesenheit des Stromzählers. In Fig. 6b ist der Stromzähler auf die Tragplatte 1 aufgesetzt, jedoch noch nicht verschoben. Fig. 6c zeigt die Zwischenstellung, in welcher die Überbrückungsteile 15a die Anschlusselemente 12a noch kurzschließen. In Fig. 6d ist der Zähler angeschlossen und zwischen einem Ende der Überbrückungsteile 15a und dem betreffenden Anschlusselement 12a ist eine Luft- und Kriechstrecke 22a gebildet.

In einem in Fig. 7 gezeigten Zustand sind die Überbrückungsteile 15a soweit zurückgezogen, dass bei 34 eine Trennstrecke gebildet ist, deren Länge der anliegenden Netzspannung genügt. In der in Fig. 7 gezeigten Position befinden sich die Überbrückungsteile 15a bei Anlieferung eines die Vorrichtung verwendenden Zähler- und Verteilerschranks. In dieser Position sind die Überbrückungsteile über eine nicht gezeigte Vorrichtung arretierbar, die sich mit einem durch eine der Öffnungen 10 geführten Spezialwerkzeug lösen lässt. Zum Beispiel kann durch das Werkzeug eine die Verbindungsteile in der gezeigten Position haltende Widerhakenformschlusshalterung gelöst werden.

Fig. 8 zeigt einen Zähler- und Verteilerschrank, an welchem Stromzähler in der vorangehend beschriebenen Weise angeschlossen werden können. Die geringe Breite der Anschlussvorrichtung erlaubt eine so geringe Breite der Zählergehäuse, dass auf herkömmlichen Zählerplätzen zwei Zähler 29 und 30 untergebracht werden können. Dazwischen besteht sogar noch Raum für unter der Zählertragplatte angeordnete Kabelkanäle, wie bei 31 angedeutet ist. Oberhalb der in ihren Abmessungen kleinen Zähler 29,30 besteht Raum für ein gesondertes Feld 32, in dem das Energieversorgungsunternehmen Steuereinrichtungen u. dgl. plazieren kann.

Die Zählertragplatte kann zur Aufnahme herkömmlicher, durch Zählerkreuz anbringbare Zähler vorbereitet sein, wobei zwischen den Zählern ein Schlitz für die Anbringung eines waagerechten Zählerkreuzschenkels und einer Öffnung 33 zur Kabeldurchführung vorzusehen wäre. Ein vertikaler Zählerkreuzschenkel lässt sich innerhalb des Feldes 32 zur Befestigung einer Geräte tragenden Hutschiene oder direkt zur Befestigung von Geräten benutzen.

Die Vorrichtung könnte Bestandteil des Adapters sein, der in der inhaltlich neben der DE 100 52 998 A1 hier einbezogenen deutschen Patentanmeldung 102 61 204.6 beschrieben ist und welcher sich an herkömmlichen Zählerplätzen anbringen lässt, um Stromzähler der beschriebenen Art aufzunehmen. Dieser Adapter könnte oberhalb des Zählers ein durch das Versorgungsunternehmen nutzbares Fach entsprechend dem Feld 32 aufweisen.

Ferner bietet die Erfindungslösung Platz, unter den Zählern zwischen den Haken 4 und Kontaktstiften L3,L3' noch einen weiteren Kabelkanal für den Anschluss von Zusatzeinrichtung oder/und zum Zähler führender Kabel zu bilden.

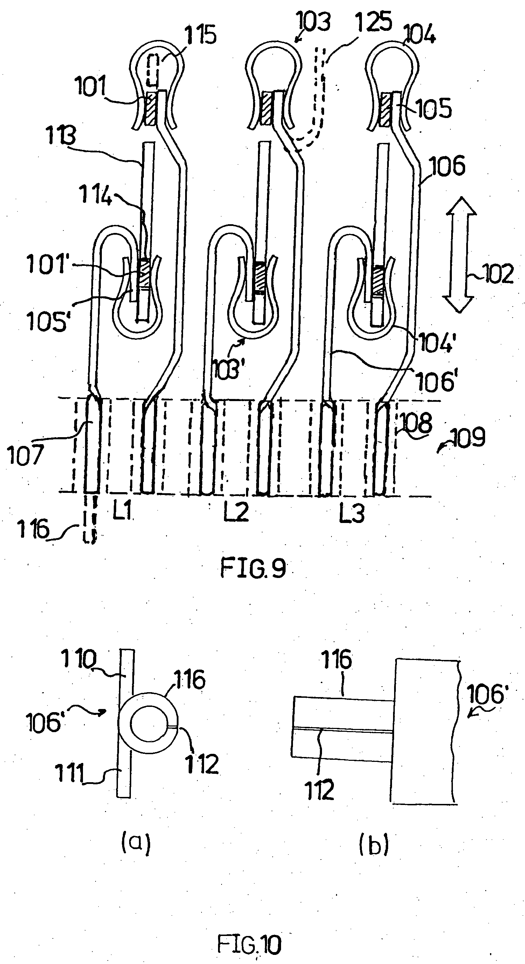

Mit dem Bezugszeichen 101 bzw. 101' sind in Fig. 9 im Querschnitt längliche Kontaktstifte bezeichnet, die von einer Bodenfläche eines Stromzählergehäuses vorstehen und durch Schlitze in einer den Stromzähler aufnehmenden Tragplatte hindurchragen. Der Stromzähler und die Tragplatte sind in Fig. 9 nicht gezeigt. Entsprechend drei Stromphasen L1, L2 und L3 sind drei Paare solcher Kontaktstifte 101,101' vorgesehen.

Der Stromzähler lässt sich auf der Tragplatte in einer Führung verschieben, so dass sich die Kontaktstifte 101,101' gemäß Pfeil 102 hin- und herbewegen können.

Zur Herstellung elektrischer Verbindungen mit den Kontaktstiften 101,101' dienen Anschlusselemente 103 bzw. 103', welche eine in dem betreffenden Ausführungsbeispiel etwa U-förmig gebogene Feder 104 bzw. 104' aus einem Federwerkstoff und einen Anschlussleiter 105 bzw. 105' aus Kupfer zur Sicherung einer ausreichenden Kontaktierung aufweisen.

Der Anschlussleiter 105 bzw. 105' geht einstückig in ein massives Leiterstück 106 bzw. 106' über, wobei Anschlussleiter und Leiterstück aus einem einzigen, gebogenen Blechstreifen gebildet sind.

Die gebogenen Leiterstücke 106,106' weisen jeweils ein flaches Druckstück 107 auf, das in eine Buchse 108 einer Anschlussleiste 109 geführt und durch Verdrehung eines Endabschnitts der Leiterstücke 106,107 gebildet ist. Strichlinien bei 125 deuten an, dass die Leiterstücke 106 auch zu einer oberhalb der Anschlusselemente 103 gelegenen weiteren Anschlussleiste, insbesondere einer Hauptleiteranschlussklemme führen können.

Abweichend von der in Fig. 9 gezeigten Ausführungsform könnten an den Leiterstücken 106,106', wie bei 116 durch Strichlinien angedeutet ist, auch Steckeransätze 116 gebildet sein, die von der Anschlussleiste 109 vorstehen und mit einer weiteren Anschlussleiste verbindbar sind. Letztere Ausführungsform kommt insbesondere dann in Betracht, wenn die gezeigte Vorrichtung Bestandteil eines Adapters für einen Stromzähler ist, und der Adapter mit dem angekoppelten Zähler an eine Zählersteckklemme auf einer für die Aufnahme eines anderen Stromzählers vorgesehenen Tragplatte gekoppelt werden soll. In dem betrachteten Fall werden die Leiterstücke durch die Anschlussleiste 109 hindurchgeführt oder es sind andere Einrichtungen zum Führen und Halten der Leiterstücke vorgesehen.

Wie Fig. 10 erkennen lässt, sind zur Bildung des Steckeransatzes 116 die Leiterstückblechstreifen unter Erzeugung von Schnittflächen 110 und 111 an ihren Längsrändern eingeschnitten und die durch die einander gegenüberliegenden Einschnitte teilweise abgetrennten Blechendstücke um die Streifenlängsachse gerollt, wobei Randflächen der Blechendstücke bei 112 aneinanderstoßen.

Das Bezugszeichen 113 weist auf Verbindungsstücke hin, welche die Anschlussleiter 105,105' bei Abwesenheit eines Stromzählers elektrisch miteinander verbinden. Die vorzugsweise durch einen Kupferblechstreifen gebildeten Verbindungsstücke 113 weisen jeweils eine Randausnehmung 114 für den Eingriff des betreffenden Kontaktstifts 101' auf, so dass die Verbindungselemente 113 gemäß Pfeil 102 durch Verschiebung des Stromzählers hin- und herbewegbar sind.

Halterungs- und Führungsteile für die Federn 104, die Leiterstücke 106 und die Verbindungsstücke 113 sind in Fig. 9 nicht gezeigt. Solche Teile können z.B. einstückig mit der obengenannten Tragplatte verbunden sein.

Beim Aufsetzen eines Zählers auf die genannte Tragplatte greifen die Kontaktstifte 101' in die Randausnehmungen 114 ein, während die Kontaktstifte 101 in die bei 115 angedeutete Stellung innerhalb der Feder 104 gelangen. Mit der Verschiebung des Stromzählers auf der Tragplatte in eine Anschlussposition verschieben sich die Kontaktstifte 101,101' in die in Fig. 9 gezeigten Stellungen, in welchen die Überbrückung durch die Verbindungsstücke 113 aufgehoben ist und die Stiftpaare 101,101' in elektrischer Verbindung mit den Anschlusselementen 104,104' stehen. In einer Zwischenstellung sind sowohl die Kontaktstifte 101 und 101' als auch beide Enden der Verbindungsstücke 113 mit dem betreffenden Anschlussleiter 105 bzw. 105' verbunden.

In den nachfolgenden Figuren sind gleiche oder gleichwirkende Teile mit derselben Bezugszahl wie in Fig. 9 und 10 bezeichnet, wobei den betreffenden Bezugszahlen jeweils der Buchstabe a oder c beigefügt ist.

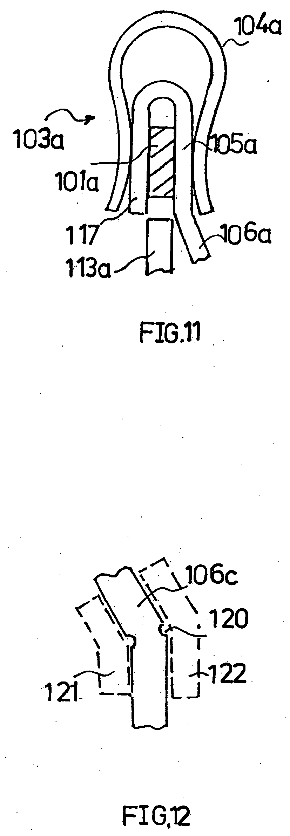

Das Ausführungsbeispiel gemäß Fig. 11 für ein Anschlusselement 103a unterscheidet sich von den vorangehend gezeigten Anschlusselementen 103 dadurch, dass ein einstückig mit einem Leiterstück 106a verbundener Anschlussleiter 105a U-förmig mit einem weiteren Schenkel 117 ausgebildet ist, so dass ein Kontaktstift 101a beidseitig gegen den Anschlussleiter anliegt. Eine U-förmige Feder 104a liegt mit ihren beiden Schenkeln gegen die Außenseiten der Schenkel des U-förmigen Anschlussleiters 105a an.

Ein in Fig. 12 ausschnittsweise dargestelltes Leiterstück 106c weist an einer Biegungsstelle einander gegenüberliegende Einkerbungen 120 auf, die für eine solche Flexibilität des Leiterstücks sorgen, dass Toleranzabweichungen des Leiterstücks und ggf. des das Leiterstück haltender, z.B. mit der Trägerplatte verbundener Haltestege 121 und 122 ausgeglichen werden können.

## Patentansprüche

1. Anschlussvorrichtung für einen Stromzähler (1), der ein Gehäuse (2) aufweist, von dessen gegen eine Tragplatte (7) der Anschlußvorrichtung anlegbarem Boden (3) durch Öffnungen (10) in der Tragplatte (7) hindurchführbare Kontaktelemente (L1-L3,L1'-L3') entsprechend wenigstens einer Stromphase vorstehen, welche durch Verschiebung des auf der Tragplatte (7) geführten Gehäuses mit Strom zu- und abführenden Anschlusselementen (12,12') der Anschlußvorrichtung auf der dem Stromzähler (1) abgewandten Seite der Tragplatte verbindbar sind, wobei die Anschlusselemente (12,12') an den Kontaktelementen (L1-L3,L1'-L3') zangenartig mit durch die Verschiebebewegung der Kontaktelemente aufspreizbaren federkraftbeaufschlagten Zangenbacken (13,14) angreifen,
**dadurch gekennzeichnet,**
**dass** die Anschlusselemente (12,12') durch einen in Verschiebungsrichtung des Stromzählers (1) verschiebbar geführten Blechstreifen (15) der Anschlußvorrichtung unter zangenartigem Angreifen der Zangenbacken (13,14) an dem Blechstreifen (15) überbrückbar sind und der Blechstreifen (15) mit einer Randausnehmung (24) für den Eingriff eines der Kontaktelemente (L1-L3,L1'-L3') ausgebildet ist, durch das sich der Blechstreifen beim Anschluss des Stromzählers (1) aus einer Überbrückungsposition in eine Offenstellung verschieben lässt.

2. Anschlussvorrichtung nach Anspruch 1,
**dadurch gekennzeichnet,**
**dass** die Dicken des Blechstreifens und des Kontaktelements übereinstimmen.

3. Anschlussvorrichtung nach einem der Ansprüche 1 oder 2,
**dadurch gekennzeichnet,**
**dass** die Anschlusselemente (12,12') in einer Zwischenstellung des Überbrückungsteils (15) sowohl durch das Überbrückungsteil (15) als auch den Stromzähler (1) verbunden sind.

4. Anschlussvorrichtung nach einem der Ansprüche 1 bis 3,
**dadurch gekennzeichnet,**
**dass** das Überbrückungsteil (15a) in eine Trennposition mit einem der Netzspannung genügenden Trennabstand verschiebbar ist.

5. Anschlussvorrichtung nach einem der Ansprüche 1 bis 4,
**dadurch gekennzeichnet,**
**dass** die Zangenbacken durch die beiden Schenkel (13,14) einer im wesentlichen U-förmigen Feder gebildet sind.

6. Anschlussvorrichtung nach einem der Ansprüche 1 bis 5,
**dadurch gekennzeichnet,**
**dass** auf wenigstens einer der Backeninnenseiten ein Anschlussleiter (23) aus Kupfer gebildet ist.

7. Anschlussvorrichtung nach einem der Ansprüche 1 bis 6,
**dadurch gekennzeichnet,**
**dass** die Anschlusselemente (12) voneinander unabhängig durch das Überbrückungsteil (15) und das Kontaktelement (L1'-L3') aufspreizbare Zangenbackenteile (20,21) aufweisen.

8. Anschlussvorrichtung nach einem der Ansprüche 1 bis 7,
**dadurch gekennzeichnet,**
**dass** Überbrückungsteile für mehrere Stromphasen untereinander durch isolierende Teile verbunden sind.

9. Anschlussvorrichtung nach einem der Ansprüche 1 bis 8,
**dadurch gekennzeichnet,**
**dass** die Kontaktelemente Kontaktstifte mit einer länglichen Querschnittsfläche sind, deren Längsachse sich in der Vorschubrichtung des Stromzählers (1) erstreckt.

10. Anschlussvorrichtung nach einem der Ansprüche 1 bis 9,
**dadurch gekennzeichnet,**
**dass** der Stromzähler (1) auf der Tragplatte (7) durch Schlitzöffnungen (8) in der Tragplatte (7) geführt ist, in welche vom Boden (3) des Gehäuses (2) vorstehende, die Tragplatte (7) hintergreifende Haken (4) eingreifen.

11. Anschlussvorrichtung nach einem der Ansprüche 1 bis 10,
**dadurch gekennzeichnet,**
**dass** die Anschlusselemente (12) auf der dem Stromzähler (1) abgewandten Seite der Tragplatte (7) an der Tragplatte (7) angebracht sind.

12. Anschlussvorrichtung nach einem der Ansprüche 4 bis 11,
**dadurch gekennzeichnet,**
**dass** das Überbrückungsteil (15) in der Trennposition arretierbar und die Arretierung mittels eines durch eine der Öffnungen (9) einführbares Spezialwerkzeug lösbar ist.

13. Anschlussvorrichtung nach einem der Ansprüche 1 bis 12,
**dadurch gekennzeichnet,**
**dass** auf wenigstens einer der Backeninnenseiten ein Anschlussleiter (105,105') aus Kupfer gebildet ist, der mit einem massiven, zu einer Anschlussklemme (109) führenden Leiterstück (106,106') in Verbindung steht, und dass der Anschlussleiter (105,105') einstückig mit dem Leiterstück (106,106') und das Leiterstück (106,106') unmittelbar mit der Anschlussklemme (109) verbunden ist.

14. Anschlussvorrichtung nach Anspruch 13,
**dadurch gekennzeichnet,**
**dass** der Anschlussleiter (105,105') und das damit einstückig verbundene Leiterstück (106,106') einen Blechstreifen aufweist, der ggf. durch Biegung vorgeformt ist.

15. Anschlussvorrichtung nach Anspruch 13 oder 14,
**dadurch gekennzeichnet,**
**dass** ein mit dem Leiterstück (106,106') verbundener Steckeransatz (116) für die Verbindung mit der Anschlussklemme (109) durch Einschneiden des Blechstreifens an den Längsrändern und Biegen, vorzugsweise Rollen, der durch die Einschnitte abgetrennten Endstücke des Blechstreifens um die Streifenlängsachse hergestellt ist.

16. Anschlussvorrichtung nach einem der Ansprüche 13 bis 15,
**dadurch gekennzeichnet,**
**dass** ein mit dem Leiterstück (106,106') verbundener Steckeransatz (116) durch eine Anschlussleiste (109) hindurchgeführt ist und einen von der Anschlussleiste (109) vorsteht.

17. Anschlussvorrichtung nach einem der Ansprüche 13 bis 16,
**dadurch gekennzeichnet,**
**dass** der Anschlussleiter (105,105') einschenklig oder zweischenklig in U-Form mit einem am freien Ende in das Leiterstück (106,106') übergehenden U-Schenkel ausgebildet ist.

18. Anschlussvorrichtung nach einem der Ansprüche 13 bis 17,
**dadurch gekennzeichnet,**
**dass** eine gegen das Kontaktelement (101,101';101a) anlegbare Feder (104,104';104a) zum Druck des Kontaktelements gegen den Anschlussleiter (105,105',105a) vorgesehen ist.

19. Anschlussvorrichtung nach einem der Ansprüche 13 bis 18,
**dadurch gekennzeichnet,**
**dass** eine U-förmige Feder (104,104';104a) mit einem U-Schenkel gegen das Kontaktelement (101,101') und mit dem anderen U-Schenkel gegen den Anschlussleiter (105,105') oder mit ihren beiden U-Schenkeln gegen die Außenseiten der Schenkel eines U-förmigen Anschlussleiters (105,105a) anlegbar ist.

20. Anschlussvorrichtung nach einem der Ansprüche 13 bis 19,
**dadurch gekennzeichnet,**
**dass** der Anschlussleiter oder/und das Leiterstück zur Beaufschlagung der Zangenbacken mit einer Federkraft selbstfedernd ist/sind.

21. Anschlussvorrichtung nach einem der Ansprüche 13 bis 20,
**dadurch gekennzeichnet,**
**dass** das Leiterstück (106c) diesem Flexibilität verleihende Schwachstellen (120) zum Ausgleich von Abmessungstoleranzen aufweist.

22. Anschlussvorrichtung nach einem der Ansprüche 14 bis 21,
**dadurch gekennzeichnet,**
**dass** die Leiterstücke zwischen Haltestegen (120,121) einlegbar sind.

## Claims

1. Connecting device for an electricity meter (1), which comprises a housing (2), from the base (3) of which, which can be applied against a support plate (7) of the connecting device, contact elements (L1-L3, L1'-L3') which can be guided through openings (10) in the support plate (7) project corresponding to at least one current phase, which, by displacement of the housing guided on the support plate (7), can be connected, on the side of the support plate facing away from the electricity meter (1), to connecting elements (12, 12') of the connecting device supplying and removing current,
wherein the connecting elements (12, 12') engage pincer-like on the contact elements (L1-L3, L1'-L3') with spring force-loaded sprung jaws (13, 14) which can be spread apart by the displacement movement of the contact elements,
**characterised in that**
the connecting elements (12, 12') being able to be bridged by a metal strip (15) of the connecting device guided displaceably in displacement direction of the electricity meter (1) by means of the pincer-like gripping of the spring jaws (13, 14) on the metal strip (15) and the metal strip (15) being designed to have an edge recess (24) for the engagement of one of the contact elements (L1-L3, L1'-L3'), by means of which the metal strip on connecting the electricity meter (1) can be pushed out of a bridging position into an open position.

2. Connecting device according to claim 1,
**characterised in that**
the thicknesses of the metal strip and the contact element coincide.

3. Connecting device according to any one of claims 1 or 2,
**characterised in that**
the connecting elements (12, 12') are connected in an intermediate position of the bridging part (15) both by the bridging part (15) and the electricity meter (1).

4. Connecting device according to any one of claims 1 to 3,
**characterised in that**
the bridging part (15a) can be displaced into a separating position with a separation distance sufficient for mains voltage.

5. Connecting device according to any one of claims 1 to 4,
**characterised in that**
the sprung jaws are formed by the two legs (13, 14) of an essentially U-shaped spring.

6. Connecting device according to any one of claims 1 to 5,
**characterised in that**
on at least one of the jaw inner sides a connecting lead (23) made of copper is formed.

7. Connecting device according to any one of claims 1 to 6,
**characterised in that**
the connecting elements (12) have sprung jaw parts (20, 21) which can be independently spread apart from one another by the bridging part (15) and the contact element (L1'-L3').

8. Connecting device according to any one of claims 1 to 7,
**characterised in that**
bridging parts for a plurality of current phases are connected to one another by insulating parts.

9. Connecting device according to any one of claims 1 to 8,
**characterised in that**
the contact elements are contact pins with an elongated cross-sectional surface, the longitudinal axis of which extends in the advance direction of the electricity meter (1).

10. Connecting device according to any one of claims 1 to 9,
**characterised in that**
the electricity meter (1) is guided on the support plate (7) through slit openings (8) in the support plate (7), into which hooks (4) protruding from the base (3) of the housing (2) and gripping behind the support plate (7) engage.

11. Connecting device according to any one of claims 1 to 10,
**characterised in that**
the connecting elements (12) are attached onto the support plate (7) on the side of the support plate (7) facing away from the electricity meter (1).

12. Connecting device according to any one of claims 4 to 11,
**characterised in that**
the bridging part (15) can be locked in the separating position and the locking can be released by means of a special tool which can inserted through one of the openings (9).

13. Connecting device according to any one of claims 1 to 12,
**characterised in that**
on at least one of the jaw inner sides a connecting lead (105, 105') made of copper is formed which is in connection with a solid lead piece (106, 106') leading to a connecting clamp (109), and **in that** the connecting lead (105, 105') is connected in one piece to the lead piece (106, 106') and the lead piece (106, 106') is connected directly to the connecting clamp (109).

14. Connecting device according to claim 13,
**characterised in that**
the connecting lead (105, 105') and the lead piece (106, 106') connected to the latter in one-piece comprises a metal strip which is possibly preformed by bending.

15. Connecting device according to claim 13 or 14,
**characterised in that**
a plug part (116) connected to the lead piece (106, 106') is formed for connection with the connecting clamp (109) by cutting into the metal strip on the longitudinal edges and bends, preferably rolls, of the end pieces of the metal strip separated by the cuts about the strip longitudinal axis.

16. Connecting device according to any one of claims 13 to 15,
**characterised in that**
a plug part (116) connected to the lead piece (106, 106') is guided through a connecting strip (109) and projects from the connecting strip (109).

17. Connecting device according to any one of claims 13 to 16,
**characterised in that**
the connecting lead (105, 105') is designed to have a single leg or two legs in a U-shape with a U-leg passing at the free end into the lead piece (106, 106').

18. Connecting device according to any one of claims 13 to 17,
**characterised in that**
a spring (104, 104'; 104a) which can be applied against the contact element (101, 101'; 101 a) is provided for pushing the contact element against the connecting lead (105, 105'; 105a).

19. Connecting device according to any one of claims 13 to 18,
**characterised in that**
a U-shaped spring (104, 104'; 104a) can be applied with one U-leg against the contact element (101, 101') and with the other U-leg against the connecting lead (105, 105') or with both its U-legs against the outsides of the leg of a U-shaped connecting lead (105, 105a).

20. Connecting device according to any one of claims 13 to 19,
**characterised in that**
the connecting lead and/or the lead piece is/are themselves resilient for applying a spring force to the sprung jaws.

21. Connecting device according to any one of claims 13 to 20,
**characterised in that**
the lead piece (106c) has weak points (120) giving the latter flexibility for compensating for dimensional tolerances.

22. Connecting device according to any one of claims 14 to 21,
**characterised in that**
the lead pieces can be placed between holding webs (120, 121).

## Revendications

1. Dispositif de connexion pour un compteur d'électricité (1), qui présente un boîtier (2) avec un fond (3) pouvant être appliqué contre une plaque de support (7) du dispositif de connexion, duquel font saillie des éléments de contact (L1-L3, L1'-L3') pouvant être passés à travers des ouvertures (10) dans la plaque de support (7), correspondant à au moins une phase de courant, lesquels peuvent être reliés du côté de la plaque de support opposé au compteur d'électricité (1) à des éléments de connexion (12, 12') d'arrivée et de départ de courant du dispositif de connexion par coulissement du boîtier guidé sur la plaque de support (7), les éléments de connexion (12, 12') agissant sur les éléments de contact (L1-L3, L1'-L3') à la manière d'une pince au moyen de mâchoires de pince (13, 14) sollicitées par la force d'un ressort, pouvant être écartées par le mouvement de coulissement des éléments de contact,
**caractérisé en ce**
**que** les éléments de connexion (12, 12') peuvent être pontés par une bande de tôle (15) du dispositif de connexion guidée coulissante dans la direction de coulissement du compteur d'électricité (1), les mâchoires de pince (13, 14) agissant à la manière d'une pince sur la bande de tôle (15), et la bande de tôle (15) étant formée avec un évidement marginal (24) pour l'engagement d'un des éléments de contact (L1-L3, L1'-L3'), par lequel la bande de tôle peut être déplacée d'une position de pontage dans une position ouverte lors de la connexion du compteur d'électricité (1).

2. Dispositif de connexion selon la revendication 1,
**caractérisé en ce**
**que** les épaisseurs de la bande de tôle et de l'élément de contact concordent.

3. Dispositif de connexion selon l'une des revendications 1 ou 2,
**caractérisé en ce**
**que** dans une position intermédiaire de la partie de pontage (15), les éléments de connexion (12, 12') sont reliés à la fois par la partie de pontage (15) et par le compteur d'électricité (1).

4. Dispositif de connexion selon l'une des revendications 1 à 3,
**caractérisé en ce**
**que** la partie de pontage (15a) peut être déplacée dans une position de séparation présentant une distance de séparation suffisante par rapport à la tension du réseau.

5. Dispositif de connexion selon l'une des revendications 1 à 4,
**caractérisé en ce**
**que** les mâchoires de pince sont formées par les deux branches (13, 14) d'un ressort sensiblement en forme de U.

6. Dispositif de connexion selon l'une des revendications 1 à 5,
**caractérisé en ce**
**qu'**un conducteur de connexion (23) en cuivre est formé sur au moins un des côtés intérieurs de mâchoire.

7. Dispositif de connexion selon l'une des revendications 1 à 6,
**caractérisé en ce**
**que** les éléments de connexion (12) présentent des parties de mâchoire de pince (20, 21) pouvant être écartées indépendamment l'une de l'autre par la partie de pontage (15) et l'élément de contact (L1'-L3').

8. Dispositif de connexion selon l'une des revendications 1 à 7,
**caractérisé en ce**
**que** des parties de pontage pour plusieurs phases de courant sont reliées entre elles par des parties isolantes.

9. Dispositif de connexion selon l'une des revendications 1 à 8,
**caractérisé en ce**
**que** les éléments de contact sont des broches de contact présentant une surface de section transversale allongée, dont l'axe longitudinal s'étend dans la direction de déplacement du compteur d'électricité (1).

10. Dispositif de connexion selon l'une des revendications 1 à 9,
**caractérisé en ce**
**que** le compteur d'électricité (1) est guidé sur la plaque de support (7) par des ouvertures (8) en forme de fente dans la plaque de support (7), dans lesquelles s'engagent des crochets (4) faisant saillie du fond (3) du boîtier (2), saisissant la plaque de support (7) par derrière.

11. Dispositif de connexion selon l'une des revendications 1 à 10,
**caractérisé en ce**
**que** les éléments de connexion (12) sont disposés sur la plaque de support (7) du côté de la plaque de support (7) détourné du compteur d'électricité (1).

12. Dispositif de connexion selon l'une des revendications 4 à 11,
**caractérisé en ce**
**que** la partie de pontage (15) peut être verrouillée dans la position de séparation et le verrouillage peut être libéré au moyen d'un outil spécial pouvant être introduit à travers l'une des ouvertures (9).

13. Dispositif de connexion selon l'une des revendications 1 à 12,
**caractérisé en ce**
**qu'**un conducteur de connexion (105, 105') en cuivre est formé sur au moins un des côtés intérieurs de mâchoire, lequel est relié à un segment de conducteur (106, 106') massif, conduisant à une borne de connexion (109), et que le conducteur de connexion (105, 105') est relié d'un seul tenant au segment de conducteur (106, 106') et le segment de conducteur (106, 106') directement à la borne de connexion (109).

14. Dispositif de connexion selon la revendication 13,
**caractérisé en ce**
**que** le conducteur de connexion (105, 105') et le segment de conducteur (106, 106') reliée à celui d'un seul tenant présentent une bande de tôle qui est, le cas échéant, préformée par cintrage.

15. Dispositif de connexion selon la revendication 13 ou 14,
**caractérisé en ce**
**qu'**une embase de fiche (116) reliée au segment de conducteur (106, 106') et destinée à la liaison avec la borne de connexion (109) est réalisée par entaillage de la bande de tôle sur les bords longitudinaux et cintrage, de préférence roulage, des bouts de la bande de tôle séparés par les entailles autour de l'axe longitudinal de la bande.

16. Dispositif de connexion selon l'une des revendications 13 à 15,
**caractérisé en ce**
**qu'**une embase de fiche (116) reliée au segment de conducteur (106, 106') est passée à travers une barrette de connexion (109) et fait saillie de la barrette de connexion (109).

17. Dispositif de connexion selon l'une des revendications 13 à 16,
**caractérisé en ce**
**que** le conducteur de connexion (105, 105') est réalisé avec une branche ou avec deux branches et en forme de U, avec une branche de U se prolongeant par le segment de conducteur (106, 106') à son extrémité libre.

18. Dispositif de connexion selon l'une des revendications 13 à 17,
**caractérisé en ce**
**qu'**un ressort (104, 104' ; 104a) pouvant être appliqué contre l'élément de contact (101, 101' ; 101a) est prévu pour presser l'élément de contact contre le conducteur de connexion (105, 105' ; 105a).

19. Dispositif de connexion selon l'une des revendications 13 à 18,
**caractérisé en ce**
**qu'**un ressort en forme de U (104, 104' ; 104a) peut être appliqué par une branche de U contre l'élément de contact (101, 101') et par l'autre branche de U contre le conducteur de connexion (105, 105') ou par ses deux branches de U contre les côtés extérieurs des branches d'un conducteur de connexion (105, 105a) en forme de U.

20. Dispositif de connexion selon l'une des revendications 13 à 19,
**caractérisé en ce**
**que** le conducteur de connexion ou/et le segment de conducteur est/sont à élasticité propre pour soumettre les mâchoires de pince à une force de ressort.

21. Dispositif de connexion selon l'une des revendications 13 à 20,
**caractérisé en ce**
**que** le segment de conducteur (106c) présente des points de faiblesse (120) qui lui confèrent de la souplesse pour compenser les tolérances dimensionnelles.

22. Dispositif de connexion selon l'une des revendications 14 à 21,
**caractérisé en ce**
**que** les segments de conducteur peuvent être insérés entre des barrettes de maintien (120, 121).
